# EUROPEAN PATENT APPLICATION

(11) **EP 4 770 400 A1**
(43) Date of publication of application: **01.07.2026**
(21) Application number: 25217138.4
(22) Date of filing: 19.11.2025
(51) Int. Cl.: H10N 60/01, H10N 60/12

(54) **METHOD OF MANUFACTURING JOSEPHSON JUNCTION ELEMENT AND JOSEPHSON JUNCTION ELEMENT**

(30) Priority: 26.12.2024 JP 2024230631
(71) Applicant: FUJITSU LIMITED, Kawasaki-shi, Kanagawa 211-8588 (JP)
(72) Inventor: NAKAMURA, Makoto, Kawasaki-shi, 211-8588 (JP)
(74) Representative: Haseltine Lake Kempner LLP

(57) **Abstract**

A method of manufacturing a Josephson junction element includes forming a lower electrode (20) on a substrate (10) by using a superconducting material, depositing a first insulating film (30) on the substrate to cover the lower electrode, depositing a superconducting film on the first insulating film, and forming an upper electrode (40) by etching the superconducting film, the upper electrode covering an entire lower electrode in plan view and having an outer peripheral edge located outside an outer peripheral edge of the lower electrode.

## Description

### FIELD

A certain aspect of the present embodiments relates to a method of manufacturing a Josephson junction element and a Josephson junction element.

### BACKGROUND

There has been known a quantum bit device including a quantum bit in which a Josephson junction element and a capacitor are connected in parallel. It is also known to use a Josephson junction element in an amplifier connected to a readout terminal of the quantum bit. The Josephson junction element has a structure in which an insulating film is interposed between a lower electrode and an upper electrode each formed of a superconducting material. Various methods are known as a method of manufacturing a Josephson junction element (for example, Japanese National Publication of International Patent Application No. 2019-528577, Japanese Patent Application Publication No. 62-81075, U.S. Patent Application Publication No. 2017/0179193 and U.S. Patent Application Publication No. 2015/0179916).

### SUMMARY

It is conceivable to form a Josephson junction element by depositing a first superconducting film serving as a lower electrode, an insulating film, and a second superconducting film serving as an upper electrode on a substrate and then patterning the films by etching. However, in this case, a damage layer is formed in the insulating film by the etching, and the characteristics of the Josephson junction element may deteriorate.

According to one aspect, it is desirable to suppress the deterioration of the characteristics of the Josephson junction element.

According to an aspect of the present disclosure, there is provided a method of manufacturing a Josephson junction element, including: forming a lower electrode on a substrate by using a superconducting material; depositing a first insulating film on the substrate to cover the lower electrode; depositing a superconducting film on the first insulating film; and forming an upper electrode by etching the superconducting film, the upper electrode covering an/the entire lower electrode in plan view and having an outer peripheral edge located outside an outer peripheral edge of the lower electrode.

According to another aspect there is provided a Josephson junction element comprising, a substrate, a lower electrode provided on the substrate and formed of a superconducting material, a first insulating film provided on the lower electrode in contact with the lower electrode, and an upper electrode provided on the first insulating film in contact with the first insulating film and formed of a superconducting material in a region overlapping the lower electrode in plan view, wherein the upper electrode covers an/the entire lower electrode in plan view, and an outer peripheral edge of the upper electrode is located outside an outer peripheral edge of the lower electrode, and the first insulating film is provided under the upper electrode over an/the entire upper electrode.

### BRIEF DESCRIPTION OF THE DRAWINGS

Reference is made, by way of example only, to the following drawings, in which:
FIG. 1A is a cross-sectional view of a Josephson junction element in accordance with a first embodiment.
FIG. 1B is a plan view of a lower wiring, a lower electrode, an insulating film, and an upper electrode in the first embodiment.
FIGs. 2A to 2C are cross-sectional views illustrating a method of manufacturing the Josephson junction element in accordance with the first embodiment (Part 1).
FIGs. 3A to 3C are cross-sectional views illustrating a method of manufacturing the Josephson junction element in accordance with the first embodiment (Part 2).
FIGs. 4A to 4C are cross-sectional views illustrating a method of manufacturing the Josephson junction element in accordance with the first embodiment (Part 3).
FIG. 5 is a cross-sectional view of a Josephson junction element according to a comparative example.
FIGs. 6A to 6C are cross-sectional views illustrating a method for manufacturing the Josephson junction element according to the comparative example (Part 1).
FIGs. 7A to 7C are cross-sectional views illustrating a method for manufacturing the Josephson junction element according to the comparative example (Part 2).
FIG. 8 is a cross-sectional view for explaining a problem that occurs in the Josephson junction element according to the comparative example.
FIG. 9 is a cross-sectional view of a Josephson junction element in accordance with a second embodiment.
FIGs. 10A to 10C are cross-sectional views illustrating a method of manufacturing the Josephson junction element in accordance with the second embodiment.
FIGs. 11A to 11C are cross-sectional views illustrating another example of the method of manufacturing the Josephson junction element in accordance with the second embodiment.

### EFFECT

According to one aspect, it is possible to suppress the deterioration of the characteristics of the Josephson junction element.

### DESCRIPTION OF EMBODIMENTS

Hereinafter, embodiments of the present disclosure will be described with reference to the drawings.

### [First Embodiment]

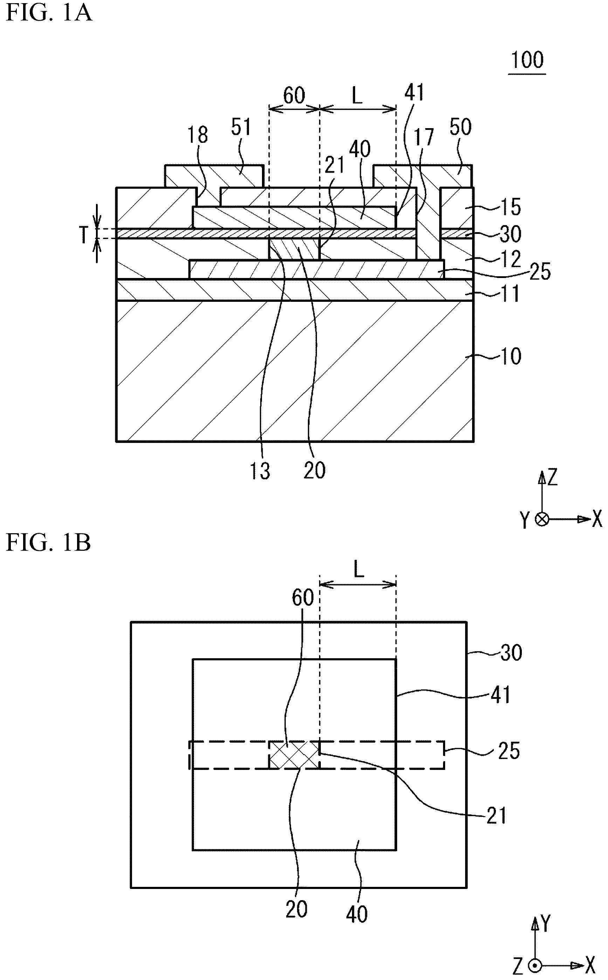

FIG. 1A is a cross-sectional view of a Josephson junction element 100 in accordance with a first embodiment, and FIG. 1B is a plan view of a lower wiring 25, a lower electrode 20, an insulating film 30, and an upper electrode 40 in the first embodiment. As illustrated in FIG. 1A, an insulating film 11 is provided on a substrate 10. The substrate 10 is, for example, a silicon (Si) substrate. The insulating film 11 is, for example, a silicon oxide (SiO₂) film.

The lower wiring 25 is provided on the insulating film 11. The lower wiring 25 is formed of a superconducting material. For example, the lower wiring 25 is formed of aluminum (Al). An insulating film 12 is provided on the insulating film 11 so as to cover the lower wiring 25. The insulating film 12 is, for example, a silicon oxide (SiO₂) film.

The insulating film 12 has an opening 13 reaching the lower wiring 25. The lower electrode 20 in contact with the lower wiring 25 is embedded in the opening 13. The lower electrode 20 is formed of a superconducting material. For example, the lower electrode 20 is formed of aluminum (Al). The upper surface of the lower electrode 20 and the upper surface of the insulating film 12 are flush with each other.

The insulating film 30 is provided on the insulating film 12 and the lower electrode 20. The insulating film 30 is provided in contact with the lower electrode 20. The insulating film 30 is, for example, an aluminum oxide (Al₂O₃) film.

The upper electrode 40 is provided on the insulating film 30. The upper electrode 40 is provided in contact with the insulating film 30. The upper electrode 40 is formed of a superconducting material. For example, the upper electrode 40 is formed of aluminum (Al). A region where the lower electrode 20 and the upper electrode 40 face each other with the insulating film 30 interposed therebetween serves as a Josephson junction portion 60.

An insulating film 15 is provided on the insulating film 30 so as to cover the upper electrode 40. The insulating film 15 is, for example, a silicon oxide (SiO₂) film. An opening 17 reaching the lower wiring 25 is provided in the insulating film 15, the insulating film 30, and the insulating film 12. An opening 18 reaching the upper electrode 40 is provided in the insulating film 15. A lead-out wiring 50 connected to the lower wiring 25 is provided in the opening 17. A lead-out wiring 51 connected to the upper electrode 40 is provided in the opening 18. The lead-out wirings 50 and 51 are formed of a superconducting material. For example, the lead-out wirings 50 and 51 are formed of aluminum (Al).

As illustrated in FIG. 1A and FIG. 1B, in plan view (when viewed from the + Z direction), an outer peripheral edge 41 of the upper electrode 40 is located outside an outer peripheral edge 21 of the lower electrode 20, and the upper electrode 40 covers the entire lower electrode 20. A shortest interval L between the outer peripheral edge 41 and the outer peripheral edge 21 is equal to or larger than a thickness T of the insulating film 30 (interval L ≥ thickness T). Since the upper electrode 40 is larger than the lower electrode 20, the area of the Josephson junction portion 60 is defined by the lower electrode 20. The area of the Josephson junction portion 60 is, for example, 0.04 µm² to 0.8 µm². In plan view, the insulating film 30 is provided under the upper electrode 40 over the entire upper electrode 40.

### [Manufacturing Method]

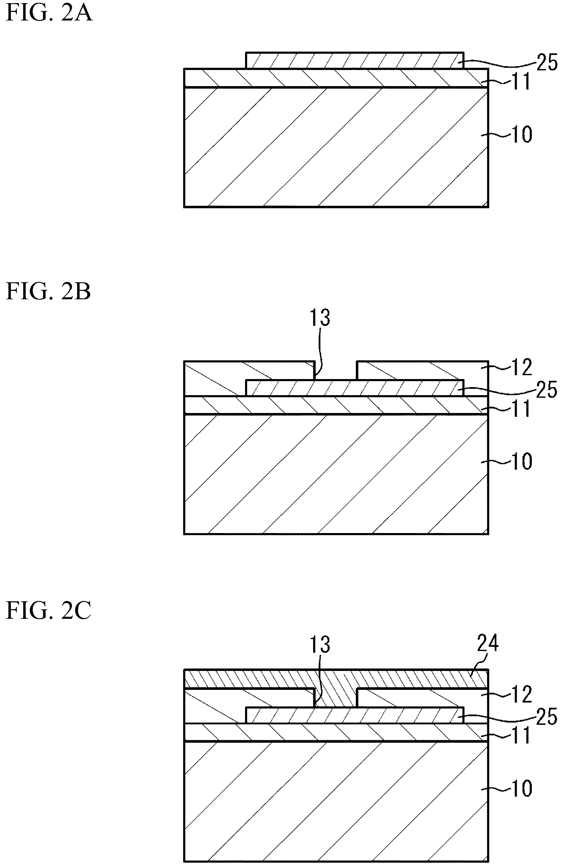

FIG. 2A to FIG. 4C are cross-sectional views illustrating a method of manufacturing the Josephson junction element 100 in accordance with the first embodiment. As illustrated in FIG. 2A, the insulating film 11 is formed on the substrate 10. For example, the insulating film 11, which is a SiO₂ film, is formed on the substrate 10 by thermally oxidizing the upper surface of the substrate 10, which is a Si substrate. The thickness of the insulating film 11 is, for example, 100 nm. Next, a superconducting film is deposited on the insulating film 11 by, for example, a sputtering method, a chemical vapor deposition (CVD) method, or a vacuum evaporation method, and then the superconducting film is patterned by a photolithography method and an etching method to form the lower wiring 25. As the superconducting film, for example, an Al film is used. In the case of using the Al film, the Al film is patterned by reactive ion etching using, for example, a chlorine-based gas to form the lower wiring 25. The thickness of the lower wiring 25 is, for example, 200 nm.

As illustrated in FIG. 2B, the insulating film 12 is deposited on the insulating film 11 so as to cover the lower wiring 25. For example, the insulating film 12 as a side SiO2 film is deposited to a thickness of 400 nm using the CVD method. Thereafter, the surface of the insulating film 12 is planarized by using, for example, a chemical mechanical polishing (CMP) method. The thickness of the insulating film 12 on the lower wiring 25 is, for example, 200 nm. Next, the opening 13 is formed in the insulating film 12 to expose the lower wiring 25. For example, when the insulating film 12 is a SiO₂ film, the opening 13 is formed by reactive ion etching using a fluorine-based gas. The insulating film 12 may be formed by polishing the lower wiring 25 by the CMP method until the lower wiring 25 is exposed, and then depositing a SiO₂ film by the CVD method again.

As illustrated in FIG. 2C, a superconducting film 24 is deposited on the insulating film 12 so as to fill the opening 13. For example, the superconducting film 24 is deposited to a thickness of 300 nm by the sputtering method, the CVD method, or the vacuum evaporation method. As the superconducting film 24, for example, an Al film is used. When the superconducting film 24 is deposited by the sputtering method, a native oxide film on the surface of the lower wiring 25 exposed in the opening 13 may be removed by reverse sputtering before the deposition.

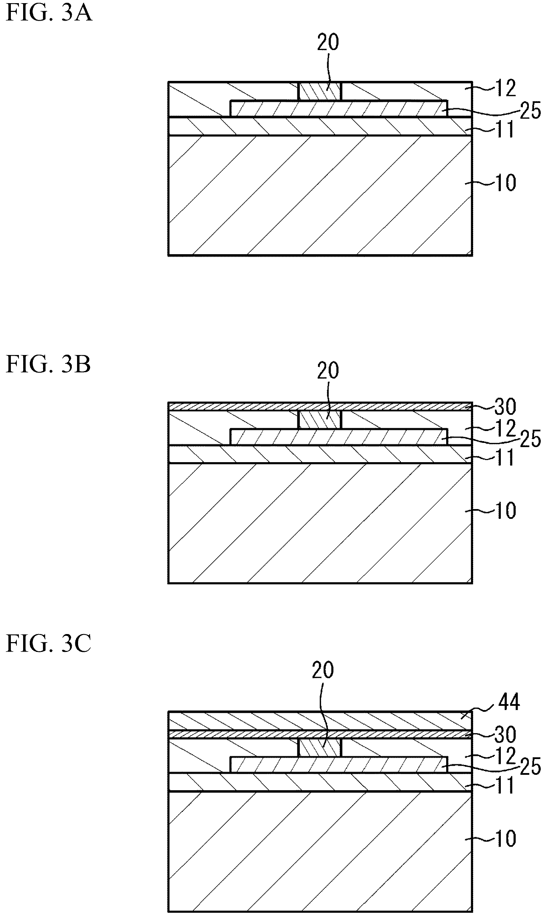

As illustrated in FIG. 3A, the superconducting film 24 on the insulating film 12 is removed by, for example, the CMP method until the surface of the insulating film 12 is exposed. As a result, the superconducting film 24 remains only in the opening 13 of the insulating film 12, and the lower electrode 20 made of the superconducting film 24 is formed in the opening 13. The upper surface of the lower electrode 20 and the upper surface of the insulating film 12 are flush with each other.

As illustrated in FIG. 3B, the surface of the lower electrode 20 is processed using an organic solution (for example, an organic alkaline solution such as TMAH (Tetramethyl ammonium hydroxide)), and a contaminated layer and a damaged layer on the surface of the lower electrode 20 are removed. Next, the insulating film 30 is deposited on the insulating film 12 and the lower electrode 20. For example, the insulating film 30 is deposited to a thickness of 20 nm by using an atomic layer deposition (ALD) method, the sputtering method, or the CVD method. As the insulating film 30, for example, a Al₂O₃ film is used.

As illustrated in FIG. 3C, a superconducting film 44 is deposited on the insulating film 30. The superconducting film 44 is deposited to a thickness of 20 nm by using, for example, the sputtering method, the CVD method, or the vacuum evaporation method. As the superconducting film 44, for example, an Al film is used.

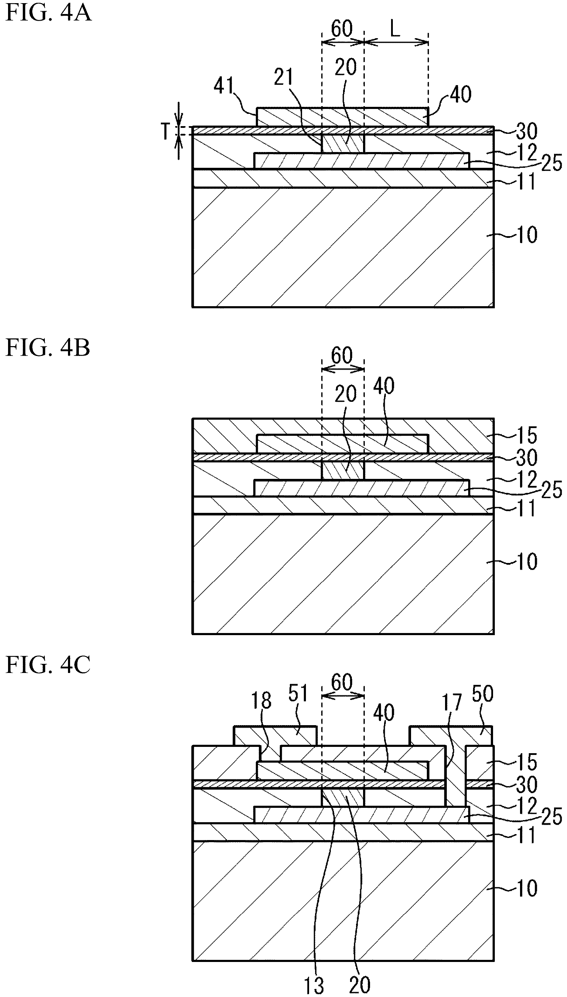

As illustrated in FIG. 4A, the upper electrode 40 is formed by patterning the superconducting film 44 by the photolithography method and the etching method so as to form the Josephson junction portion 60, which is a region overlapping the lower electrode 20 with the insulating film 30 interposed therebetween. At this time, the upper electrode 40 is formed so as to cover the entire lower electrode 20 and so that the outer peripheral edge 41 of the upper electrode 40 is located outside the outer peripheral edge 21 of the lower electrode 20 in plan view. For example, the upper electrode 40 is formed so that the shortest interval L between the outer peripheral edge 41 of the upper electrode 40 and the outer peripheral edge 21 of the lower electrode 20 is equal to or larger than the thickness T of the insulating film 30. When the superconducting film 44 is an Al film, the superconducting film 44 is patterned by reactive ion etching using a chlorine-based gas to form the upper electrode 40.

As illustrated in FIG. 4B, the insulating film 15 is deposited on the insulating film 30 so as to cover the upper electrode 40. For example, the insulating film 15, which is a SiO₂ film, is deposited to a thickness of 400 nm by using the CVD method. Thereafter, the surface of the insulating film 15 is planarized by the CMP method.

As illustrated in FIG. 4C, the insulating film 15, the insulating film 30, and the insulating film 12 are etched to form the opening 17 through which the lower wiring 25 is exposed. The insulating film 15 is etched to form the opening 18 through which the upper electrode 40 is exposed. When the insulating film 15 and the insulating film 12 are SiO₂ films, the insulating film 15 and the insulating film 12 are etched by reactive ion etching using a fluorine-based gas. When the insulating film 30 is an Al₂O₃ film, the insulating film 30 is etched by an ion milling method. Next, the lead-out wiring 50 embedded in the opening 17 and connected to the lower wiring 25 and the lead-out wiring 51 embedded in the opening 18 and connected to the upper electrode 40 are formed of a superconducting material (for example, Al). The lead-out wirings 50 and 51 are formed by using, for example, a lift-off method. As described above, the Josephson junction element 100 according to the first embodiment is formed.

### [Comparative Example]

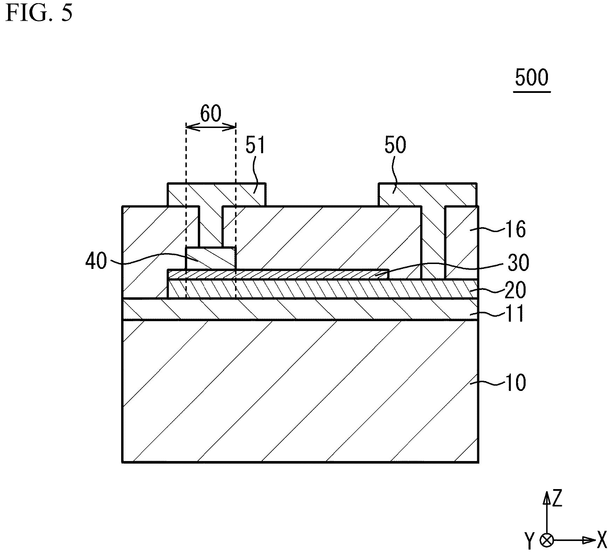

FIG. 5 is a cross-sectional view of a Josephson junction element 500 according to a comparative example. As illustrated in FIG. 5, the insulating film 11 is provided on the substrate 10. The lower electrode 20 is provided on the insulating film 11. The insulating film 30 is provided on the lower electrode 20. The upper electrode 40 is provided on the insulating film 30. Thus, the Josephson junction portion 60 is formed as a region where the lower electrode 20 and the upper electrode 40 face each other with the insulating film 30 interposed therebetween. In the comparative example, the upper electrode 40 is smaller than the lower electrode 20 in plan view. Therefore, the area of the Josephson junction portion 60 is defined by the upper electrode 40.

An insulating film 16 is provided on the substrate 10 so as to cover the lower electrode 20, the insulating film 30, and the upper electrode 40. An opening is provided in the insulating film 16, and the lead-out wiring 50 connected to the lower electrode 20 and the lead-out wiring 51 connected to the upper electrode 40 are provided in the opening.

### [Manufacturing Method of Comparative Example]

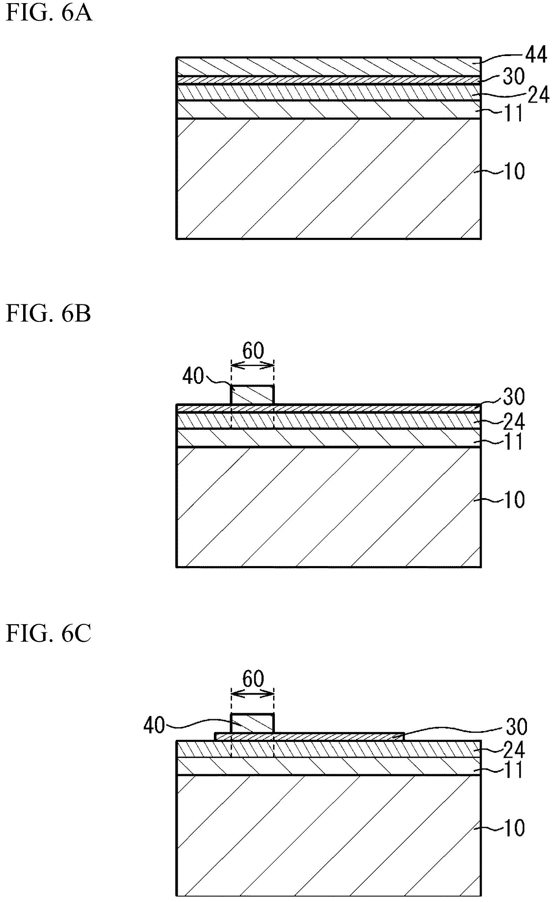

FIG. 6A to FIG. 7C are cross-sectional views illustrating a method for manufacturing the Josephson junction element 500 according to the comparative example. As illustrated in FIG. 6A, the insulating film 11 is formed on the substrate 10 by, for example, thermal oxidation. The superconducting film 24 is deposited on the insulating film 11 by the sputtering method, the CVD method, or the vacuum evaporation method, for example. The insulating film 30 is deposited on the superconducting film 24 by using, for example, the ALD method, the sputtering method, or the CVD method. The superconducting film 44 is deposited on the insulating film 30 by the sputtering method, the CVD method, or the vacuum evaporation method, for example.

As illustrated in FIG. 6B, the superconducting film 44 is patterned by the photolithography method and the etching method to form the upper electrode 40. The area of the Josephson junction portion 60 is defined by the upper electrode 40.

As illustrated in FIG. 6C, the insulating film 30 is patterned by the photolithography method and the etching method.

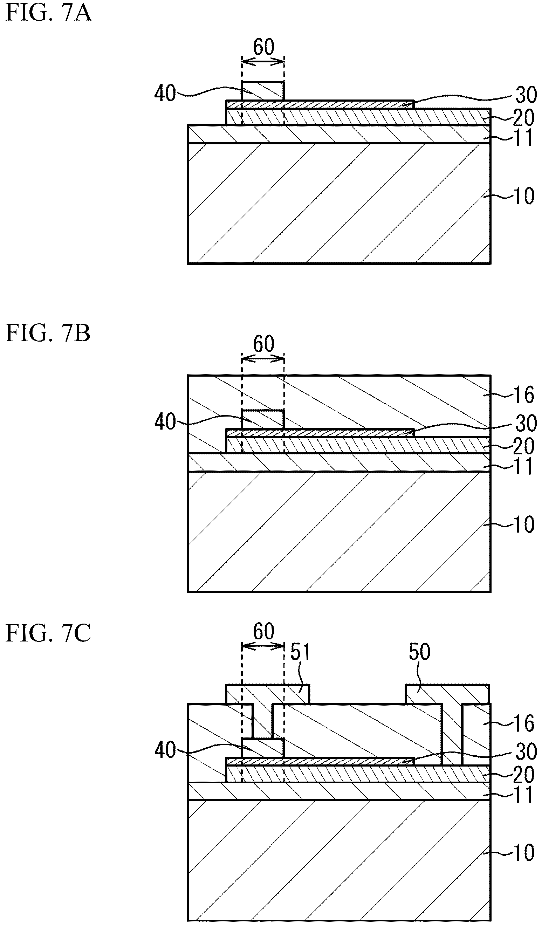

As illustrated in FIG. 7A, the superconducting film 24 is patterned by the photolithography method and the etching method to form the lower electrode 20.

As illustrated in FIG. 7B, the insulating film 16 is formed on the insulating film 11 by using, for example, the CVD method so as to cover the lower electrode 20, the insulating film 30, and the upper electrode 40.

As illustrated in FIG. 7C, an opening is formed in the insulating film 16 by the photolithography method and the etching method. The lead-out wiring 50 connected to the lower electrode 20 and the lead-out wiring 51 connected to the upper electrode 40 are formed in the opening. The lead-out wirings 50 and 51 are formed by, for example, the lift-off method. As described above, the Josephson junction element 500 according to the comparative example is formed.

### [Problem of Comparative Example]

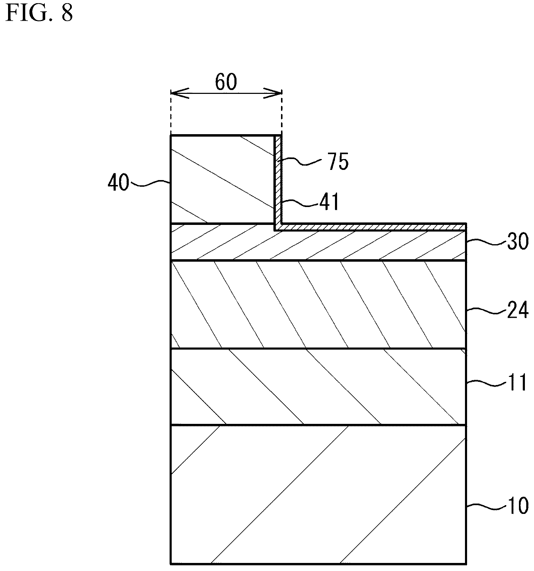

FIG. 8 is a cross-sectional view illustrating a problem that occurs in the Josephson junction element 500 according to the comparative example. As described with reference to FIGs. 6A and 6B, in the comparative example, the upper electrode 40 is formed by depositing the superconducting film 24, the insulating film 30, and the superconducting film 44 on the substrate 10 and then etching the superconducting film 44. In this case, as illustrated in FIG. 8, a damage layer 75 is formed on the side surface of the upper electrode 40 and the upper surface of the insulating film 30 by etching. For example, when the upper electrode 40 is formed by patterning the superconducting film 44 by reactive ion etching, the damage layer 75 is formed on the side surface of the upper electrode 40 and the upper surface of the insulating film 30 by exposure to plasma of the reactive ion etching. Since the Josephson junction portion 60 is defined by the upper electrode 40, a part of the damage layer 75 is formed in the Josephson junction portion 60. The insulation property is reduced in the region of the insulating film 30 where the damage layer 75 is formed. As a result, an effective area of the Josephson junction portion 60 may be changed from a desired size. As a result, the characteristics (e.g., current-voltage characteristics) of the Josephson junction element may not become desired characteristics and may be deteriorated.

On the other hand, according to the first embodiment, as illustrated in FIG. 4A, when the upper electrode 40 is formed by etching the superconducting film 44, the upper electrode 40 is formed so as to cover the entire lower electrode 20 in plan view and so that the outer peripheral edge 41 of the upper electrode 40 is located outside the outer peripheral edge 21 of the lower electrode 20. Thus, even when a damage layer is formed in the insulating film 30 (first insulating film) when the superconducting film 44 is etched, the damage layer is formed away from the Josephson junction portion 60. Therefore, the influence of the damage layer on the Josephson junction portion 60 is suppressed, and thus the deterioration of the characteristics of the Josephson junction element can be suppressed.

In addition, by forming the Josephson junction element 100 by the manufacturing method of the first embodiment, as illustrated in FIGs. 1A and 1B, the upper electrode 40 covers the entire lower electrode 20, and the outer peripheral edge 41 of the upper electrode 40 is located outside the outer peripheral edge 21 of the lower electrode 20 in plan view. The insulating film 30 is provided under the upper electrode 40 over the entire upper electrode 40. According to such the Josephson junction element 100, the influence of the damage layer on the Josephson junction portion 60 is suppressed, and thus the deterioration of the characteristics of the Josephson junction element can be suppressed.

In the first embodiment, as illustrated in FIG. 4A, the upper electrode 40 is formed such that the shortest interval L between the outer peripheral edge 41 of the upper electrode 40 and the outer peripheral edge 21 21 of the lower electrode 20 is equal to or larger than the thickness T of the insulating film 30. This can suppress the influence of the damage layer on the Josephson junction portion 60, and suppress the deterioration of the characteristics of the Josephson junction element. From the viewpoint of suppressing the deterioration of characteristics, the interval L is preferably 1.5 times or more, more preferably 2.0 times or more, and still more preferably 2.5 times or more the thickness T.

In the first embodiment, as illustrated in FIG. 2B, the insulating film 12 (second insulating film) having the opening 13 (first opening) is formed on the substrate 10. As illustrated in FIG. 3A, the lower electrode 20 embedded into the opening 13 is formed. As illustrated in FIG. 3B, the insulating film 30 (first insulating film) is deposited on the lower electrode 20 and the insulating film 12. Thus, the insulating film 30 is formed in a flat shape. As illustrated in FIG. 3C, the superconducting film 44 formed on the insulating film 30 is also formed in the flat shape. Therefore, as illustrated in FIG. 4A, the Josephson junction portion 60 whose area is defined by the lower electrode 20 is formed by patterning the superconducting film 44 to form the upper electrode 40. Therefore, the Josephson junction portion 60 having a desired area can be formed.

In the first embodiment, as illustrated in FIG. 3B, the insulating film 30 (first insulating film) covering the lower electrode 20 is formed after the surface of the lower electrode 20 is processed using the organic solution. This suppresses an unnecessary layer from being interposed between the lower electrode 20 and the insulating film 30, and can suppress the deterioration of the characteristics of the Josephson junction element.

In the first embodiment, as illustrated in FIG. 2A, the lower wiring 25 (first wiring) is formed on the substrate 10. As illustrated in FIG. 2B, the insulating film 12 (second insulating film) is formed on the substrate 10 so as to cover the lower wiring 25. As illustrated in FIG. 3A, the lower electrode 20 connected to the lower wiring 25 is formed in the opening 13 (first opening) formed in the insulating film 12. Thus, even when the entire lower electrode 20 is covered with the upper electrode 40, a configuration in which a voltage can be applied to the Josephson junction portion 60 can be easily obtained.

In the first embodiment, as illustrated in FIG. 3B, the insulating film 30 is deposited by the ALD method, the CVD method, or the sputtering method. For example, when the insulating film 30 is formed by thermally oxidizing the surface of the lower electrode 20, the oxidation rate is different between the central portion and the end portion of the lower electrode 20, and the insulating film 30 having a large variation in film thickness may be formed. In addition, stress may be concentrated on the end portion of the insulating film 30 due to thermal expansion or the like during oxidation. For these reasons, the characteristics of the Josephson junction element may deteriorate. However, by depositing the insulating film 30 by using the ALD method, the CVD method, or the sputtering method, the insulating film 30 that is dense as a whole and has small film thickness variation and stress concentration can be formed. Therefore, the deterioration of the characteristics of the Josephson junction element can be suppressed. In particular, by depositing the insulating film 30 using the ALD method, the controllability of the film quality and the film thickness of the insulating film 30 can be improved.

In the first embodiment, as illustrated in FIGs. 2C and 3A, the lower electrode 20 is formed by patterning the superconducting film 24 deposited by the sputtering method, the CVD method, or the vacuum evaporation method. As illustrated in FIGs. 3C and 4A, the upper electrode 40 is formed by patterning the superconducting film 44 deposited by the sputtering method, the CVD method, or the vacuum evaporation method. By depositing the superconducting films 24 and 44 by using the sputtering method, the CVD method, or the vacuum deposition method, the superconducting films 24 and 44 having small variations in film thickness can be obtained on the entire surface of the substrate 10. In particular, by depositing the superconducting films 24 and 44 by the sputtering method, the lower electrode 20 and the upper electrode 40 can be formed with less impurities, and with a dense and excellent film quality.

### [Second Embodiment]

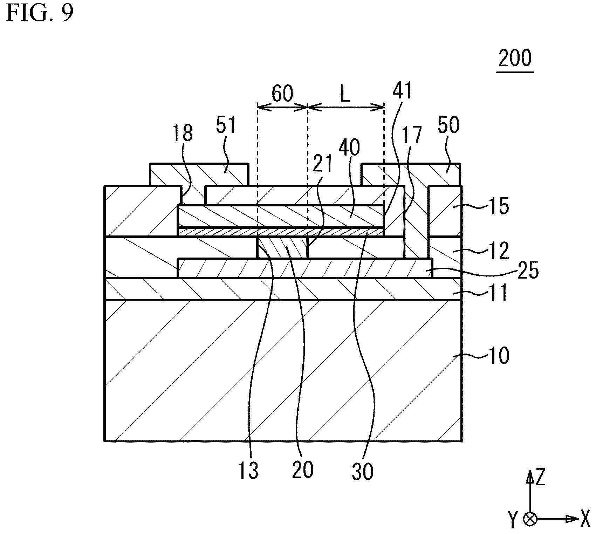

FIG. 9 is a cross-sectional view of a Josephson junction element 200 in accordance with a second embodiment. As illustrated in FIG. 9, in the second embodiment, the insulating film 30 is provided only under the upper electrode 40. Therefore, the upper electrode 40 and the insulating film 30 have the same size in plan view. The other configurations are the same as those of the first embodiment, and thus the description thereof will be omitted.

### [Manufacturing Method]

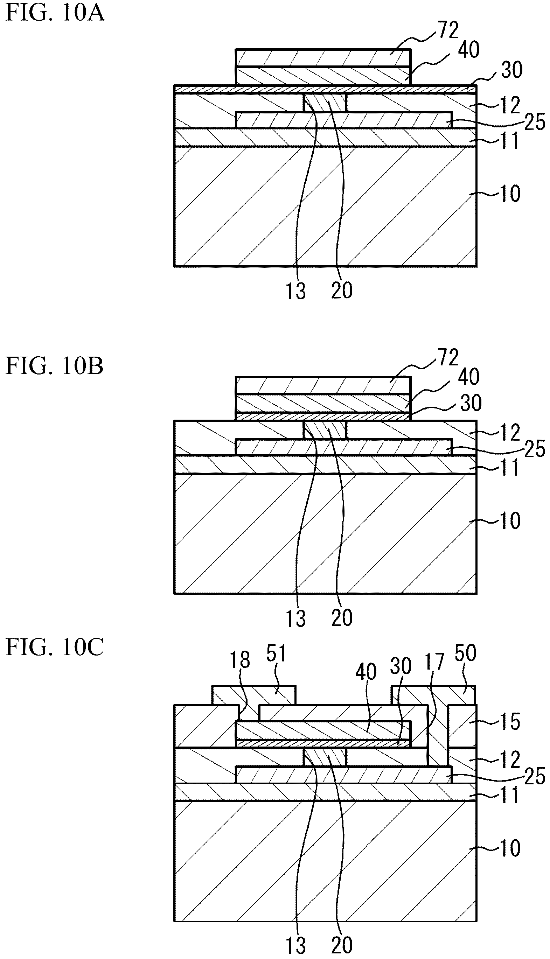

FIG. 10A to FIG. 10C are cross-sectional views illustrating a method of manufacturing the Josephson junction element 200 in accordance with the second embodiment. First, the same steps as those of the first embodiment illustrated in FIGs. 2A to 4A are performed to form the upper electrode 40 as illustrated in FIG. 10A. Here, a resist mask 72 used when the upper electrode 40 is formed by patterning the superconducting film 44 is also illustrated.

As illustrated in FIG. 10B, the insulating film 30 is etched by, for example, the ion milling method using the resist mask 72 as a mask. As a result, the insulating film 30 remains only under the upper electrode 40, and the upper electrode 40 and the insulating film 30 have the same size in plan view.

As illustrated in FIG. 10C, after the resist mask 72 is removed, the insulating film 15 is deposited on the insulating film 12 so as to cover the upper electrode 40. The insulating film 15 and the insulating film 12 are etched to form the opening 17 through which the lower wiring 25 is exposed. The insulating film 15 is etched to form the opening 18 through which the upper electrode 40 is exposed. Next, the lead-out wiring 50 embedded in the opening 17 and connected to the lower wiring 25 and the lead-out wiring 51 embedded in the opening 18 and connected to the upper electrode 40 are formed of a superconducting material (for example, Al). As described above, the Josephson junction element 200 according to the second embodiment is formed.

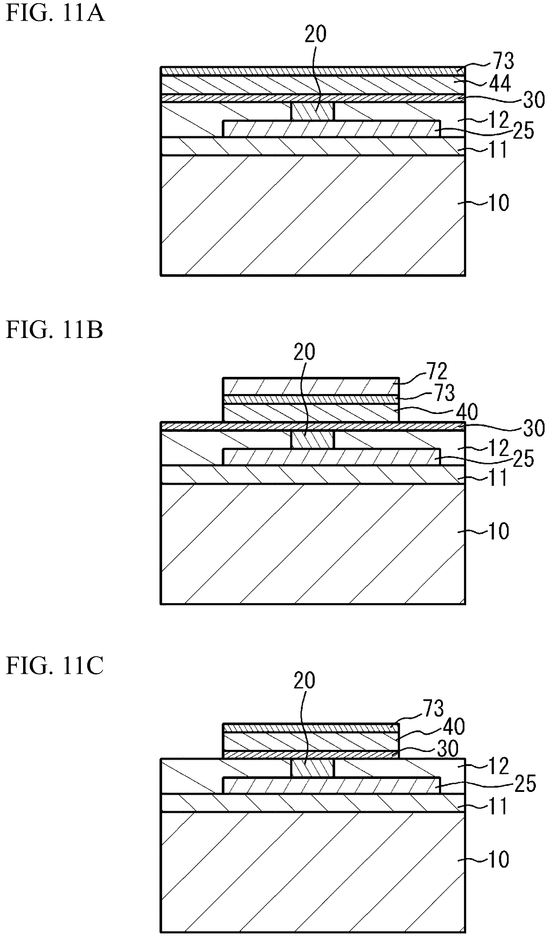

FIG. 11A to FIG. 11C are cross-sectional views illustrating another example of the method of manufacturing the Josephson junction element 200 in accordance with the second embodiment. First, the same steps as those of FIGs. 2A to 3C of the first embodiment are performed. Thereafter, as illustrated in FIG. 11A, a hard mask 73 made of, for example, titanium nitride (TiN) is deposited on the superconducting film 44.

As illustrated in FIG. 11B, the hard mask 73 and the superconducting film 44 are etched using the resist mask 72 formed on the hard mask 73 as a mask. Thereby, the upper electrode 40 is formed. When the TiN film is used for the hard mask 73, the hard mask 73 can be etched together with the superconducting film 44, which is the Al film, by reactive ion etching using a chlorine-based gas.

As illustrated in FIG. 11C, the insulating film 30 is etched by, for example, ion milling using the resist mask 72 and the hard mask 73 as masks. As a result, the insulating film 30 remains only under the upper electrode 40, and the upper electrode 40 and the insulating film 30 have the same size in plan view.

Next, after the resist mask 72 and the hard mask 73 are removed, the same process as that of FIG. 10C is performed to form the insulating film 15 covering the upper electrode 40, the lead-out wiring 50 connected to the lower wiring 25, and the lead-out wiring 51 connected to the upper electrode 40. As described above, the Josephson junction element 200 according to the second embodiment is formed.

According to the second embodiment, as illustrated in FIGs. 10B and 11C, the insulating film 30 (first insulating film) is etched using the resist mask 72 and/or the hard mask 73 (mask layer) formed on the upper electrode 40 as a mask. Thereafter, as illustrated in FIG. 10C, the insulating film 15 (third insulating film) covering the upper electrode 40 is formed, and then the opening 17 (second opening) exposing the lower wiring 25 (first wiring) is formed in the insulating film 15 and the insulating film 12. Next, the lead-out wiring 50 (second wiring) connected to the lower wiring 25 is formed in the opening 17. Thus, the opening 17 is formed in the insulating films 12 and 15, which are SiO₂ films, for example, and therefore the opening 17 can be easily formed. Therefore, the lead-out wiring 50 connected to the lower wiring 25 can be easily formed.

In the second embodiment, as illustrated in FIGs. 11B and 11C, the insulating film 30 is etched using the hard mask 73 made of TiN. When the insulating film 30 is an Al₂O₃ film, the resist mask 72 may be entirely removed during etching because the insulating film 30 is etched by ion milling. Therefore, the hard mask 73 is preferably used in addition to or instead of the resist mask 72. The hard mask 73 may be a film other than the TiN film as long as it can withstand etching by ion milling, and may be, for example, a silicon nitride (SiN) film. In the case where the TiN film is used for the hard mask 73, when the superconducting film 44 for forming the upper electrode 40 is an Al film, the hard mask 73 and the superconducting film 44 can be etched simultaneously by reactive ion etching using a chlorine-based gas.

Although the first and second embodiments have been described with reference to the case where the lower electrode 20 and the upper electrode 40 are formed of aluminum, the lower electrode 20 and the upper electrode 40 may be formed of a superconducting material other than aluminum. For example, the lower electrode 20 and the upper electrode 40 may be a single-layer film or a multilayer film containing at least one of aluminum (Al), silicon (Si), titanium (Ti), vanadium (V), zinc (Zn), gallium (Ga), germanium (Ge), antimony (Sb), tellurium (Te), yttrium (Y), zirconium (Zr), niobium (Nb), molybdenum (Mo), ruthenium (Ru), indium (In), TiN (Sn), hafnium (Hf), tantalum (Ta), and titanium nitride (TiN). The lower wiring 25 and the lead-out wirings 50 and 51 may also be a single-layer film or a multilayer film containing at least one of the above-described superconducting materials.

Although the first and second embodiments have been described with reference to the case where the insulating film 30 is formed of aluminum oxide, the insulating film 30 may be formed of an insulating film other than aluminum oxide. For example, the insulating film 30 may be a single-layer film or a multilayer film including at least one of aluminum oxide (AlO_{X}), aluminum nitride (AlN), silicon nitride (SiN), halfnium oxide (HfO₂), and tantalum oxide (Ta₂O₅). From the viewpoint of adhesion, the insulating film 30 preferably contains the same metal element as the lower electrode 20 and the upper electrode 40. For example, when the lower electrode 20 and the upper electrode 40 are formed of Al, the insulating film 30 is preferably formed of AlO_{X} or AlN. Then the lower and upper electrodes 20 and 40 are formed of Hf, the insulating film 30 is preferably formed of HfO₂. When the lower and upper electrodes 20 and 40 are formed of Ta, the insulating film 30 is preferably formed of Ta₂O₅.

Although the embodiment of the present invention is described in detail, the present invention is not limited to the specifically described embodiments and variations but other embodiments and variations may be made without departing from the scope of the claimed invention.

## Claims

1. A method of manufacturing a Josephson junction element (100, 200) comprising:
forming a lower electrode (20) on a substrate by using a superconducting material;
depositing a first insulating film (30) on the substrate to cover the lower electrode;
depositing a superconducting film on the first insulating film; and
forming an upper electrode (40) by etching the superconducting film, the upper electrode covering an entire lower electrode in plan view and having an outer peripheral edge (41) located outside an outer peripheral edge (21) of the lower electrode.

2. The method of manufacturing the Josephson junction element according to claim 1,
wherein in the forming the upper electrode, the upper electrode is formed such that a shortest interval between the outer peripheral edge of the upper electrode and the outer peripheral edge of the lower electrode is equal to or larger than a thickness of the first insulating film.

3. The method of manufacturing the Josephson junction element according to claim 1 or 2, further comprising
forming a second insulating film (12) having a first opening (13) on the substrate,
wherein the lower electrode is formed in the first opening in the forming the lower electrode, and
the first insulating film is deposited on the lower electrode and the second insulating film in the depositing the first insulating film.

4. The method of manufacturing the Josephson junction element according to any preceding claim, further comprising
performing a treatment using an organic solution on a surface of the lower electrode before the depositing the first insulating film.

5. The method of manufacturing the Josephson junction element according to claim 3, further comprising
forming a first wiring (25) on the substrate before the forming the second insulating film,
wherein the forming the second insulating film includes forming the second insulating film covering the first wiring, and
the forming the lower electrode includes forming the lower electrode connected to the first wiring.

6. The method of manufacturing the Josephson junction element according to claim 5, further comprising
etching the first insulating film using a mask layer (72, 73) formed on the upper electrode as a mask;
forming a third insulating film (15) covering the upper electrode after etching the first insulating film;
forming a second opening (17) in which the first wiring is exposed in the third insulating film and the second insulating film; and
forming a second wiring (50) connected to the first wiring in the second opening.

7. The method of manufacturing the Josephson junction element according to claim 6,
wherein the mask layer includes a hard mask layer (73) formed of titanium nitride or silicon nitride.

8. The method of manufacturing the Josephson junction element according to any preceding claim,
wherein in the depositing the first insulating film, the first insulating film is deposited by using an atomic layer deposition method, a chemical vapor deposition method, or a sputtering method.

9. The method of manufacturing the Josephson junction element according to any preceding claim,
wherein in the forming the lower electrode, the lower electrode is formed by patterning a film (24) made of the superconducting material deposited by using a sputtering method, a chemical vapor deposition method, or a vacuum deposition method, and/or
in the depositing the superconducting film, the superconducting film is deposited by using the sputtering method, the chemical vapor deposition method, or the vacuum deposition method.

10. The method of manufacturing the Josephson junction element according to any preceding claim,
wherein the first insulating film contains the same metal element as the lower electrode and the upper electrode.

11. A Josephson junction element comprising:
a substrate (10);
a lower electrode (20) provided on the substrate and formed of a superconducting material;
a first insulating film (30) provided on the lower electrode in contact with the lower electrode; and
an upper electrode (40) provided on the first insulating film in contact with the first insulating film and formed of a superconducting material in a region overlapping the lower electrode in plan view;
wherein the upper electrode covers an entire lower electrode in plan view, and an outer peripheral edge (41) of the upper electrode is located outside an outer peripheral edge (21) of the lower electrode, and
the first insulating film is provided under the upper electrode over an entire upper electrode.

12. The Josephson junction element according to claim 11,
wherein a shortest interval between the outer peripheral edge of the upper electrode and the outer peripheral edge of the lower electrode is equal to or larger than a thickness of the first insulating film.

13. The Josephson junction element according to claim 11 or 12, further comprising
a second insulating film (12) provided on the substrate and having an opening (13),
wherein the lower electrode is provided in the opening, and the first insulating film is provided from on the lower electrode to on the second insulating film.

14. The Josephson junction element according to claim 13, further comprising
a first wiring (25) provided on the substrate,
wherein the second insulating film is provided on the substrate to cover the first wiring, and
the lower electrode is connected to the first wiring.

15. The Josephson junction element according to claim 14, further comprising:
a third insulating film (15) covering the upper electrode; and
a second wiring (50) provided in an opening (17) formed in the third insulating film and the second insulating film and connected to the first wiring;
wherein the upper electrode and the first insulating film have the same size as each other in plan view.
